# EUROPEAN PATENT SPECIFICATION

(11) **EP 2 891 670 B1**
(45) Date of publication and mention of the grant of the patent: **01.02.2017**
(21) Application number: 13833973.4
(22) Date of filing: 27.08.2013
(51) Int. Cl.: C08F 299/00, H01L 29/786, H01L 51/05, H01L 51/30, C09D 4/06

(54) **CURABLE COMPOSITION AND METHOD FOR PRODUCING CURED FILM**
HÄRTBARE ZUSAMMENSETZUNG UND VERFAHREN ZUR HERSTELLUNG EINES GEHÄRTETEN FILMS
COMPOSITION RÉTICULABLE ET PROCÉDÉ DE PRODUCTION DE FILM RÉTICULÉ

(30) Priority: 31.08.2012 JP 2012192116
(43) Date of publication of application: 08.07.2015
(73) Proprietor: Asahi Glass Company, Limited, Tokyo 100-8405 (JP)
(72) Inventor: ITO, Masahiro, Tokyo 100-8405 (JP); TSURUOKA, Kaori, Tokyo 100-8405 (JP)
(74) Representative: Müller-Boré & Partner Patentanwälte PartG mbB
(86) International application number: PCT/JP2013/072887
(87) International publication number: WO 2014/034671

(56) References cited:
- WO-A1-2009/154254
- WO-A1-2011/162001
- WO-A1-2013/089204
- JP-A- 2005 513 788
- JP-A- 2010 163 521

## Description

### TECHNICAL FIELD

The present invention relates to a curable composition, and a method for producing a cured film using the curable composition.

### BACKGROUND ART

In the electronics field, development of an insulating material having a low dielectric constant is in progress. For example, as a material suitable for formation of an interlayer insulation film of a semiconductor device, a gate insulation film of a thin film transistor (TFT), a stress relaxing layer of a rewiring layer, etc., a curable composition containing a polymer material having a low dielectric constant has been proposed.

The surface of a cured film formed from a curable composition is sometimes required to have water repellency depending upon the application of the cured film. For example, in a case where a gate insulation film is formed by a material having a low dielectric constant and an organic semiconductor layer is provided thereon, in order to increase the degree of orientation of molecules of the organic semiconductor thereby to improve the electron mobility, the surface of the gate insulation film preferably has water repellency.

With such a background, water repellency is imparted to an insulation film by incorporating a surface treating agent into a polymer material having a low dielectric constant to form the insulation film.

For example, Patent Document 1 discloses incorporation of e.g. octadecyltrichlorosilane as a surface treating agent, and Patent Document 2 discloses incorporation of a fluorinated copolymer.

### PRIOR ART DOCUMENTS

### PATENT DOCUMENTS

Patent Document 1: JP-A-2007-5698
Patent Document 2: WO2011/162001

### DISCLOSURE OF INVENTION

### TECHNICAL PROBLEM

However, octadecyltrichlorosilane as disclosed in Patent Document 1 has hydrolyzable chlorine atoms. Accordingly, if an insulation film by using octadecyltrichlorosilane is formed, the wiring of the device may be eroded by the action of the chlorine atoms. Further, the hydrolyzable chlorine atoms and water-absorbing silanol groups formed by hydrolysis will increase the leak current of the insulation film. Accordingly, an insulation film formed by using octadecyltrichlorosilane tends to be insufficient in the insulating properties.

On the other hand, the insulation film as disclosed in Patent Document 2 contains a fluorinated copolymer and thereby has not only water repellency but also oil repellency. On an insulation film having oil repellency, a semiconductor layer may be formed by a deposition method or a liquid crystalline polymer semiconductor layer may be formed by a coating method. However, the insulation film having oil repellency repels an organic solvent-based coating liquid for forming an organic film of e.g. a resist or a low molecular organic semiconductor layer. Accordingly, it is difficult to form an organic film or a low molecular organic semiconductor layer on the insulation film as disclosed in Patent Document 2 by a method using an organic solvent-based coating liquid.

Under these circumstances, the object of the present invention is to provide a curable composition from which a cured film having lipophilicity to such an extent that application of an organic solvent-based coating liquid is possible while maintaining water repellency, having sufficient insulating properties and having a low dielectric constant, is obtained, a method for producing a cured film using the curable composition, and a semiconductor device using a cured film obtained by curing the curable composition.

### SOLUTION TO PROBLEM

The present invention provides a curable composition, a coating composition, a method for producing a cured film, a substrate and a semiconductor device according to the following [1] to [15].
[1] A curable composition comprising a fluorinated polyarylene prepolymer (A) having crosslinkable functional groups,
   a compound (B) having at least two crosslinkable functional groups, having no fluorine atom and having a number average molecular weight of from 140 to 3,000,
   a compound (C) having a C₆₋₂₄ alkyl group which may have an etheric oxygen atom between carbon atoms, having crosslinkable functional groups, having no fluorine atom and having a number average molecular weight higher than 3,000 and at most 50,000, and
   a radical polymerization initiator (D).
[2] The curable composition according to [1], wherein the fluorinated polyarylene prepolymer (A) is a fluorinated polyarylene ether prepolymer having crosslinkable functional groups, obtained by reacting a fluorinated aromatic compound having a fluorine atom bonded to a carbon atom of the aromatic ring, a phenol compound having at least two phenolic hydroxy groups, and an aromatic compound having a crosslinkable functional group and a reactive group capable of being reacted in the presence of a dehydrohalogenating agent, in the presence of a dehydrohalogenating agent.
[3] The curable composition according to [1] or [2], wherein the compound (B) is a poly(meth)acrylate of a polyhydric alcohol.
[4] The curable composition according to any one of [1] to [3], wherein the compound (C) is a copolymer having the following units (c1) and the following units (c2):
   unit (c1): a unit having a C₆₋₂₄ alkyl group which may have an etheric oxygen atom between carbon atoms and having no fluorine atom nor crosslinkable functional group,
   unit (c2): a unit having a crosslinkable functional group and having no fluorine atom.
[5] The curable composition according to [4], wherein the units (c1) are units formed by polymerization of a monomer represented by the following formula (c1 m-1):

   CH₂=CX-COO-Rn (c1m-1)

   wherein X is a hydrogen atom or a methyl group, and Rn is a C₆₋₂₄ alkyl group which may have an etheric oxygen atom between carbon atoms.
[6] The curable composition according to any one of [1] to [5], wherein each of the crosslinkable functional groups in the prepolymer (A), the compound (B) and the compound (C) which are independent of one another, is a crosslinkable functional group selected from the group consisting of a vinyl(oxy) group, an allyl(oxy) group, an ethynyl group and a (meth)acryloyl(oxy) group.
[7] The curable composition according to any one of [1] to [6], wherein the compound (B) is contained in an amount of from 10 to 80 mass% based on the total amount (100 mass%) of the prepolymer (A) and the compound (B).
[8] The curable composition according to any one of [1] to [7], wherein the radical polymerization initiator (D) is a thermal polymerization initiator (D1) or a photopolymerization initiator (D2).
[9] The curable composition according to any one of [1] to [8], wherein the compound (C) is contained in an amount of from 0.1 to 20 parts by mass based on the total amount (100 mass%) of the prepolymer (A) and the compound (B).
[10] A coating composition comprising the curable composition as defined in any one of [1] to [9] and a solvent.
[11] A method for producing a cured film, which comprises forming a film of the coating composition as defined in [10] on a substrate, and heat-curing or photocuring the curable composition by a step including at least one heating step to produce a cured film, wherein the heat temperature in every heating step is at most 250°C.
[12] A substrate having a cured film of the curable composition as defined in any one of [1] to [9] formed thereon.
[13] A semiconductor device having a cured film of the curable composition as defined in any one of [1] to [9].
[14] The semiconductor device as defined in [13], which is an organic thin film transistor having the cured film as a functional film.
[15] The semiconductor device according to [14], wherein the functional film is a gate insulation film.

### ADVANTAGEOUS EFFECTS OF INVENTION

According to the curable composition and the method for producing a cured film of the present invention, it is possible to form a cured film having lipophilicity to such an extent that application of an organic solvent-based coating liquid is possible while maintaining water repellency, having sufficient insulating properties and having a low dielectric constant.

A cured film obtained by curing the curable composition of the present invention may suitably be used as a functional film of a semiconductor device such as a gate insulation film of an organic thin film transistor.

### BRIEF DESCRIPTION OF DRAWINGS

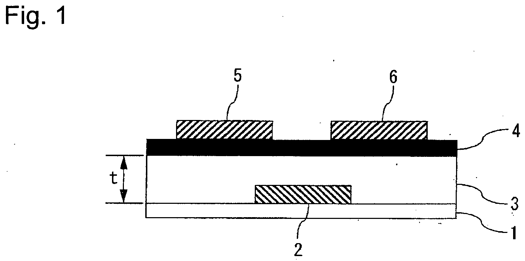

Fig. 1 is a cross sectional view schematically illustrating one example of an organic thin film transistor using a cured film formed from a curable composition of the present invention.

### DESCRIPTION OF EMBODIMENTS

In this specification, a methacryloyl group and a methacryloyloxy group will generally be referred to as a methacryloyl(oxy) group. The same applies to an acryloyl(oxy) group, a vinyl(oxy) group and an allyl(oxy) group. Further, an acryloyl group and a methacryloyl group will generally be referred to as a (meth)acryloyl group. The same applies to a (meth)acryloyloxy group. Moreover, all of such compounds will sometimes be generally referred to as a (meth)acryloyl(oxy) group.

In the present invention, a film obtained by applying a curable composition to a substrate will be referred to as "a film of a curable composition". A film obtained by applying a coating composition to a substrate will be referred to as "a film of a coating composition", and by removing the solvent, a film of a curable composition is obtained. A film obtained by curing the film of a curable composition will be referred to as "a cured film".

### [Curable composition]

The curable composition of the present invention comprises a fluorinated polyarylene prepolymer (A) having crosslinkable functional groups; a compound (B) having at least two crosslinkable functional groups, having no fluorine atom and having a number average molecular weight of from 140 to 3,000; a compound (C) having a C₆₋₂₄ alkyl group which may have an etheric oxygen atom between carbon atoms, having crosslinkable functional groups, having no fluorine atom and having a number average molecular weight of higher than 3,000 and at most 50,000; and a radical polymerization initiator (D).

In the present invention, the crosslinkable functional group is a functional group which may undergo polymerization reaction by a radical. In the present invention, by the action of an external energy, radicals are generated from the radical polymerization initiator (D), the radicals make the crosslinkable functional group undergo polymerization reaction, and by the polymerization reaction, a compound having the crosslinkable functional group undergoes reaction such as polymerization, crosslinking or chain extension. The compound having a crosslinkable functional group in the present invention is the prepolymer (A), the compound (B), the compound (C) and the like as mentioned above.

In the present invention, as an external energy, heat or light is employed. Both may be used in combination.

In a case where heat is employed as the external energy, a thermal polymerization initiator (D1) is used as the radical polymerization initiator (D). If the reaction temperature of the crosslinkable functional group is too low, the stability of the compound having the crosslinkable functional group or a composition containing it during storage cannot be secured, and accordingly the reaction temperature is preferably at least 40°C, more preferably at least 60°C, particularly preferably at least 70°C. The upper limit of the reaction temperature is at most the upper limit of the heat temperature acceptable in production of the cured film, and for example, at most the heat-resistant temperature of the substrate. As the crosslinkable functional group is reactive at a lower temperature, such a compound is applicable to a lower temperature process. For example, the reaction temperature of the crosslinkable functional group is preferably at most 250°C, particularly preferably at most 200°C.

In a case where light (actinic rays) is employed as the external energy, a photopolymerization initiator (D2) is used as the radical polymerization initiator (D). In such a case, the curable composition at an exposed portion is cured by irradiation with actinic rays. As the case requires, heating may be carried out after exposure and/or development.

The crosslinkable functional group in the present invention may, for example, be a carbon-carbon unsaturated double bond which may undergo polymerization by a radical, a carbon-carbon unsaturated triple bond which may undergo polymerization by a radical, a ring which is opened by a radical, or a group containing such a group.

Each of the above unsaturated double bond and unsaturated triple bond may be present in the interior of a molecular chain, or may be present at the terminal (hereinafter referred to as a terminal olefin type), and is preferably present at the terminal in view of high reactivity. The bond being present in the interior of a molecular chain includes presence in a part of an alicyclic ring such as a cycloolefin. The terminal olefin type crosslinkable functional group is preferably an alkenyl group having at most 4 carbon atoms or an alkynyl group having at most 4 carbon atoms.

Specifically, a vinyl(oxy) group, an allyl(oxy) group, an isopropenyl group, a 3-butenyl group, a (meth)acryloyl(oxy) group, a trifluorovinyl(oxy) group, an ethynyl group, a 1-oxocyclopenta-2,5-dien-3-yl group, a cyano group, a diaryl hydroxymethyl group, a cyclobutalene ring or an oxirane ring may be mentioned.

The crosslinkable functional group in the present invention is preferably a crosslinkable functional group selected from the group consisting of a vinyl(oxy) group, an allyl(oxy) group, an ethynyl group and a (meth)acryloyl(oxy) group, in view of high reactivity and with a view to obtaining a cured film having a high crosslink density.

Each crosslinkable functional group of the prepolymer (A) is particularly preferably a vinyl group or an ethynyl group in view of low reactivity at the time of preparation of the prepolymer (A) and favorable reactivity in the presence of the radical polymerization initiator (D).

Each crosslinkable functional group of the compound (B) is more preferably a crosslinkable functional group selected from the group consisting of a (meth)acryloyl(oxy) group in view of high reactivity and availability, and is particularly preferably an acryloyl(oxy) group in view of higher reactivity.

Each crosslinkable functional group of the compound (C) is particularly preferably a (meth)acryloyl(oxy) group in view of high reactivity with the crosslinkable functional groups of the other compounds.

With respect to the crosslinkable functional groups of the prepolymer (A), the compound (B) and the compound (C), one molecule of each compound may have two or more types of crosslinkable functional groups. Further, the crosslinkable functional groups of the prepolymer (A), the compound (B) and the compound (C) which coexist in the curable composition may be the same or different.

### (Fluorinated polyarylene prepolymer (A))

The fluorinated polyarylene prepolymer (A) (hereinafter sometimes referred to as prepolymer (A)) in the present invention has a polyarylene structure having a plurality of aromatic rings bonded by means of a single bond or a linking group, has fluorine atoms and has crosslinkable functional groups. By the curable composition containing the prepolymer (A), a low dielectric constant can be imparted to the resulting cured film.

The crosslinkable functional groups of the prepolymer (A) do not substantially undergo reaction at the time of production of the prepolymer (A), and undergo radical polymerization reaction by imparting an external energy in the presence of the radical polymerization initiator (D), to cause crosslinking between molecules of the prepolymer (A) or chain extension. Further, they are considered to be also reacted with the crosslinkable functional groups of the compound (B) or the compound (C) and integrated with them to produce a cured film. As described above, the crosslinkable functional groups of the prepolymer (A) are particularly preferably vinyl groups and ethynyl groups.

The linking group in the polyarylene structure may, for example, be an ether bond (-O-), a sulfide bond (-S-), a carbonyl group (-CO-) or a sulfonyl group (-SO₂-). Among the prepolymers (A), particularly a prepolymer having a structure in which aromatic rings each containing a fluorine atom, or an aromatic ring containing a fluorine atom and an aromatic ring containing no fluorine atom, are bonded by a linking group containing an ether bond (-O-) is referred to as a fluorinated polyarylene ether prepolymer. The prepolymer (A) in the present invention preferably comprises a fluorinated polyarylene ether prepolymer, and the prepolymer (A) particularly preferably consists solely of the fluorinated polyarylene ether prepolymer.

As a specific example of the linking group containing the ether bond, an ether bond (-O-) consisting solely of an etheric oxygen atom or an alkylene group containing an etheric oxygen atom in a carbon chain may, for example, be mentioned.

Among the prepolymers (A), particularly the fluorinated polyarylene ether prepolymer is preferred in that the molecular structure has flexibility and the flexibility of a cured film is good, since it has an etheric oxygen atom.

The prepolymer (A) has fluorine atoms. As it has fluorine atoms, the dielectric constant and the dielectric loss of the resulting cured film tend to be low, such being desirable as a material to form an insulation film. When the dielectric constant and the dielectric loss of an insulation film are low, it is possible to prevent delay of a signal propagation velocity and to obtain a device excellent in electrical properties.

Further, as it has fluorine atoms, the water absorption of the cured film becomes low, whereby it is possible to prevent a change in the bonded state at the bonded electrodes and wiring portions therearound, or it is possible to prevent deterioration (such as rusting) of metals. These properties have substantial effects to improve the reliability of a device.

As a preferred example of the prepolymer (A), a fluorinated polyarylene ether prepolymer obtained by reacting a fluorinated aromatic compound, a phenol compound and a crosslinkable functional group-containing aromatic compound in the presence of a dehydrohalogenating agent such as potassium carbonate may be mentioned. Each of the fluorinated aromatic compound, the phenol compound and the crosslinkable functional group-containing aromatic compound may be used alone or in combination of two or more. The dehydrohalogenation reaction may be carried out by a known method.

The fluorinated aromatic compound is a compound having a fluorine atom bonded to a carbon atom of the aromatic ring, and it is preferred that all the hydrogen atoms bonded to carbon atoms of the aromatic ring are substituted by fluorine atoms. As a preferred specific example, perfluoro(1,3,5-triphenylbenzene) or perfluorobiphenyl may, for example, be mentioned. This fluorinated aromatic compound is a compound having no crosslinkable functional group.

The phenol compound is a compound having at least two phenolic hydroxy groups, and is preferably a phenol compound having at least three phenolic hydroxy groups. Further, it is also preferred to use as the phenol compound a compound having at least three phenolic hydroxy groups and a compound having two phenolic hydroxy groups in combination. The phenolic hydroxy group may be a blocked phenolic hydroxy group capable of undergoing dehydrohalogenation reaction. As a preferred specific example, 1,3,5-trihydroxybenezene or 1,1,1-tris(4-hydroxyphenyl)ethane may, for example, be mentioned. This phenol compound is a compound having no crosslinkable functional group.

The crosslinkable functional group-containing aromatic compound is an aromatic compound having a crosslinkable functional group and in addition, a reactive group capable of being reacted in the presence of a dehydrohalogenating agent, and the reactive group may, for example, be a phenolic hydroxy group, a blocked phenolic hydroxy group (such as an acetoxy group), a carbon atom of an aromatic ring to which a fluorine atom is bonded, or a carbon atom of an alkyl group to which a chlorine atom or a bromine atom is bonded (for example, a chloromethyl group). As a preferred specific example of the crosslinkable functional group-containing aromatic compound, pentafluorostyrene, acetoxystyrene, chloromethylstyrene or pentafluorophenylacetylene may, for example, be mentioned.

The dehydrohalogenation reaction is carried out preferably in a solvent. The solvent is preferably a solvent containing an aprotic polar solvent such as N,N-dimethylacetamide, N,N-dimethylformamide, N-methylpyrrolidone, dimethylsulfoxide or sulfolane. The polar solvent may contain, within a range not to decrease the solubility of a prepolymer to be formed and not to impair the condensation reaction, toluene, xylene, benzene, tetrahydrofuran, benzotrifluoride, xylene hexafluoride or the like. By containing such a solvent, the polarity (dielectric constant) of the solvent is changed, and the reaction rate may be controlled. The solvent may be used alone or in combination of two or more.

The number average molecular weight (Mn) of the prepolymer (A) is preferably from 1,000 to 100,000, particularly preferably from 5,000 to 50,000. When the number average molecular weight (Mn) is at least the lower limit of the above range, flexibility of the cured film is less likely to be lowered, and when it is at most the upper limit of the above range, purification of the curable composition tends to be easy.

In this specification, the number average molecular weight (Mn) is a molecular weight calculated as polystyrene obtainable by measurement by gel permeation chromatography employing a calibration curve prepared by using a standard polystyrene sample having a known molecular weight.

### (Compound (B))

The compound (B) is a compound having at least two crosslinkable functional groups, having no fluorine atom and having a number average molecular weight of from 140 to 3,000. By the curable composition containing the compound (B), a cured film having higher hardness can be formed. The compound (B) is usually liquid at room temperature, and it is considered that in such a case, the compound (B) functions as a reactive diluting agent, thus lowering the glass transition temperature of a film of the curable composition before curing, and radical reaction becomes possible even at low temperature, whereby curing at low temperature is possible. Further, the liquid compound (B) functions as a solvent to make application of the curable composition possible. The viscosity of the curable composition can be made lower as the compound (B) has a lower viscosity or the amount of the compound (B) is larger.

The number average molecular weight (Mn) of the compound (B) is preferably from 200 to 3,000, more preferably from 220 to 2,500, particularly preferably from 240 to 2,000. When it is at least the lower limit of the above range, the boiling point tends to be high, and the curable composition is less likely to be volatilized when heated. When it is at most the upper limit of the above range, the viscosity of the compound (B) can be suppressed to be low, and therefore, a uniform curable composition can readily be obtained when the compound (B) is mixed with the prepolymer (A).

Since the compound (B) has at least two crosslinkable functional groups, molecules can be crosslinked. The compound (B) preferably has from 2 to 20, particularly preferably from 2 to 8 crosslinkable functional groups.

The crosslinkable functional groups of the compound (B) are preferably groups having no fluorine atom and undergoing reaction simultaneously with the radical polymerization reaction of the crosslinkable functional groups of the prepolymer (A).

The crosslinkable functional groups of the compound (B) induce crosslinking or chain extension by the reaction of at least the crosslinkable functional groups of the compound (B) with each other. Further, it is considered that they are reacted with the crosslinkable functional groups of the prepolymer (A) or the prepolymer (C) and they are integrated to form a cured film.

Each crosslinkable functional group of the compound (B) is preferably a (meth)acryloyl(oxy) group, a vinyl(oxy) group or an allyl(oxy) group, more preferably a (meth)acryloyl(oxy) group. The (meth)acryloyl(oxy) group is more preferably a (meth)acryloyloxy group, particularly preferably an acryloyloxy group.

The compound (B) is preferably a poly(meth)acrylate of a polyhydric alcohol. The polyhydric alcohol may be an alkane polyol, a multimer of an alkane polyol, a polyether polyol such as a polyoxyalkylene polyol, or a polyester polyol such as a polyester diol which is a condensate of a dihydric alcohol and a dibasic acid or a polyester polyol obtained by subjecting a cyclic ester to ring opening addition to a polyhydric alcohol.

Specific examples of the compound (B) include dipentaerythritol triacrylate triundecylate, dipentaerythritol pentaacrylate monoundecylate, ethoxylated isocyanuric acid triacrylate, triacrylate of ε-caprolactone-modified ethoxylated isocyanuric acid, 9,9-bis[4-(2-acryloyloxyethoxy)phenyl]fluorene, polyethylene glycol diacrylate, polyethylene glycol dimethacrylate, polypropylene glycol diacrylate, polypropylene glycol dimethacrylate, ethoxylated bisphenol A diacrylate, ethoxylated bisphenol A dimethacrylate, propoxylated bisphenol A diacrylate, propoxylated bisphenol A dimethacrylate, 1,10-decanediol diacrylate, 1,6-hexanediol diacrylate, 1,6-hexanediol dimethacrylate, 1,4-butanediol dimethacrylate, 1,3-butanediol dimethacrylate, hydroxypivalic acid neopentyl glycol diacrylate, 1,9-nonanediol diacrylate, 1,9-nonanediol dimethacrylate, neopentyl glycol diacrylate, neopentyl glycol dimethacrylate, pentaerythritol triacrylate, trimethylolpropane triacrylate, ethoxylated trimethylolpropane triacrylate, propoxylated trimethylolpropane triacrylate, triallyl cyanurate, triallyl isocyanurate, trimethallyl isocyanurate, 1,4-butanediol divinyl ether, 1,9-nonanediol divinyl ether, cyclohexane dimethanol divinyl ether, triethylene glycol divinyl ether, trimethylolpropane trivinyl ether, pentaerythritol tetravinyl ether, 2-(2-vinyloxyethoxy)ethyl acrylate, 2-(2-vinyloxyethoxy)ethyl methacrylate, trimethylolpropane diallyl ether, pentaerythritol triallyl ether, dipentaerythritol hexaacrylate, pentaerythritol tetraacrylate, an ethoxylated pentaerythritol tetraacrylate represented by the following formula (1), a propoxylated pentaerythritol tetraacrylate represented by the following formula (2), ditrimethylolpropane tetraacrylate, tricyclodecane dimethanol diacrylate, tricyclodecane dimethanol methacrylate, and a compound represented by the following formula (3).

Further, polyester acrylates (a compound obtained by modifying both terminals of a condensate of a dihydric alcohol and a dibasic acid with acrylic acid, tradename: Aronix (M-6100, M-6200, M-6250 or M-6500), manufactured by TOAGOSEI CO., LTD.; and a compound obtained by modifying a hydroxy group terminal of a condensate of a polyhydric alcohol and a polybasic acid, with acrylic acid, tradename: Aronix (M-7100, M-7300K, M-8030, M-8060, M-8100, M-8530, M-8560 or M-9050) manufactured by TOAGOSEI CO., LTD.) may also be used. These products are commercially available. The compound (B) may be used alone or in combination of two or more. 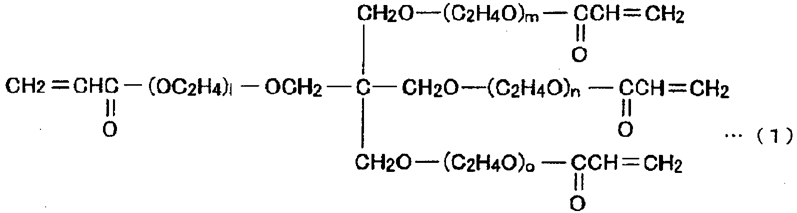 (wherein I+m+n+o is 4 to 35) 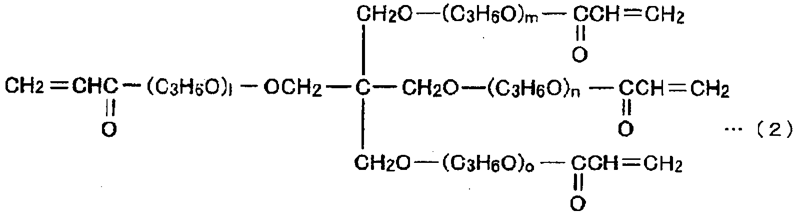 (wherein l+m+n+o is about 4) 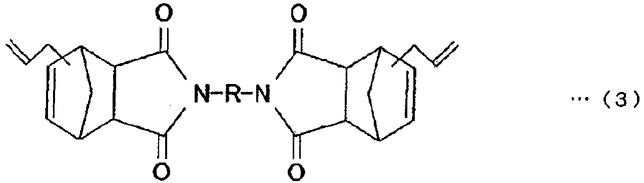 (wherein R is

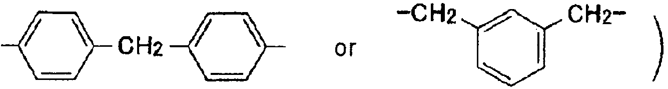

As the compound (B), ethoxylated isocyanuric acid triacrylate, 1,10-decanediol diacrylate, 1,9-nonanediol diacrylate, 1,9-nonanediol dimethacrylate, trimethylolpropane triacrylate, dipentaerythritol hexaacrylate, pentaerythritol tetraacrylate, ditrimethylolpropane tetraacrylate, tricyclodecane dimethanol diacrylate or triacrylate of ε-caprolactone modified isocyanuric acid (such as "ε-caprolactone modified tris-(2-acryloxyethyl)isocyanurate" manufactured by Shin-Nakamura Chemical Co., Ltd.) is preferred from the viewpoint of availability and reactivity.

The content of the compound (B) contained in the curable composition is preferably from 10 to 80 mass%, more preferably from 15 to 70 mass%, particularly preferably from 20 to 60 mass% based on the total amount (100 mass%) of the prepolymer (A) and the compound (B). When the proportion of the compound (B) is at least the lower limit of the above range, the curable composition will be sufficiently cured even at low temperature, and the obtainable cured film is excellent in the solvent resistance. When the proportion of the compound (B) is at most the upper limit of the above range, the dielectric constant of the cured film is sufficiently low.

### (Compound (C))

The compound (C) in the present invention is a compound having a C₆₋₂₄ alkyl group (hereinafter sometimes referred to as an Rn group) which may have an etheric oxygen atom between carbon atoms, having crosslinkable functional groups, having no fluorine atom and having a number average molecular weight of higher than 3,000 and at most 50,000. The compound (C) has crosslinkable functional groups which react with the crosslinkable functional groups of the prepolymer (A) or the compound (B) and integrated to form a cured film.

By the curable composition containing the compound (C), the surface of an obtainable film can be made lipophilic while imparting water repellency to the surface. The reason is considered as follows. Since the compound (C) has a molecular weight within the above range and has an Rn group, in the film of the curable composition on a substrate, the compound (C) moves to the surface on the opposite side from the substrate. When the cured film is formed, the compound (C) is cured near said surface, whereby water repellency and lipophilicity develop on the cured film surface.

The compound (C) may be used alone or in combination of two or more.

The Rn group of the compound (C) may be a straight chain, branched or cyclic, and is preferably a linear chain, whereby high water repellency is likely to be imparted to the surface of the cured film. The Rn group may have an etheric oxygen atom between carbon atoms.

Among C₆₋₂₄ alkyl groups, specific examples of a straight chain alkyl group include -(CH₂)₅CH₃, -(CH₂)₆CH₃, -(CH₂)₇CH₃, -(CH₂)₈CH₃, -(CH₂)₉CH₃, -(CH₂)₁₀CH₃, -(CH₂)₁₁CH₃, -(CH₂)₁₂CH₃, -(CH₂)₁₃CH₃, -(CH₂)₁₄CH₃, -(CH₂)₁₅CH₃, -(CH₂)₁₆CH₃, -(CH₂)₁₇CH₃, -(CH₂)₁₈CH₃, -(CH₂)₁₉CH₃, -(CH₂)₂₀CH₃, -(CH₂)₂₁CH₃, -(CH₂)₂₂CH₃, and -(CH₂)₂₃CH₃.

Specific examples of a branched alkyl group include -CH₂CH(CH₃)(CH₂)₂CH₃, -CH(CH₃)(CH₂)₃CH₃, -C(CH₃)₂(CH₂)₃CH₃, -C(CH₃)₂(CH₂)₄CH₃, -C(CH₃)(CH₂CH₃)(CH₂)₃CH₃, -(CH₂)₂CH(CH₃)CH₂CH₃, -(CH₂)₃CH(CH₃)₂, -CH₂CH(CH₂CH₃)(CH₂)₃CH₃, -(CH₂)₂CH(CH₃)(CH₂)₂CH₃, -CH₂CH(CH(CH₃)₂)(CH₂)₂CH(CH₃)₂, -(CH₂)₂CH(CH₃)(CH₂)₃CH(CH₃)₂, -(CH₂)₅CH(CH₃)CH₂CH₃, -(CH₂)₂CH(CH₃)CH₂C(CH₃)₃, -(CH₂)₂CH(CH₃)CH₂C(CH₃)₃, -CH(CH₃)(CH₂)₄CH₃, -CH(CH₂CH₃)(CH₂)₃CH₃, -CH(CH₂CH₃)(CH₂)₆CH₃, -CH(CH₃)(CH₂)₇CH₃, -CH(CH₂CH₂CH₃)(CH₂)₅CH₃, -CH((CH₂)₃CH₃)(CH₂)₄CH₃, -C(CH₃)₂CH(CH₃)(CH₂)₂CH₃, -C(CH₃)₂CH₂CH₂CH(CH₃)₂, -CH(CH₂CH₃)CH₂CH₂CH(CH₃)₂, -CH(CH₃)(CH₂)₃CH(CH₃)₂, -CH(CH₃)CH₂CH₂CH(CH₃)CH₂CH₃, -CH(CH₂CH₃)CH₂CH(CH₃)CH₂CH₃, -CH(CH₃)CH₂CH₂CH(CH₃)₂, -CH(CH₃)(CH₂)₇CH₃, -CH(CH₂CH₃)(CH₂)₅CH₃, -CH(CH₂CH₂CH₃)(CH₂)₄CH₃, -CH((CH₂)₃CH₃)₂, -CH(CH₃)(CH₂)₅CH₃, -CH(CH₂CH₃)(CH₂)₄CH₃, -CH((CH₂)₂CH₃)(CH₂)₃CH₃, -CH(CH₃)(CH₂)₉CH₃, -CH(CH(CH₃)₂)(CH₂)₄CH₃, -CH(CH₃)(CH₂)₁₁CH₃, -CH(CH₃)(CH₂)₁₀CH₃, -C(CH₃)(CH₂CH₃)(CH₂)₃CH(CH₃)₂, -CH((CH₃)₅CH₃)(CH₂)₆CH₃, -CH(CH₃)(CH₂)₈CH₃, -CH(CH₂CH₃)(CH₂)₇CH₃, -CH((CH₂)₂CH₃)(CH₂)₆CH₃, -CH((CH₂)₃CH₃)(CH₂)₅CH₃, -CH((CH₂)₄CH₃)₂, -CH(CH₂CH(CH₃))CH₂CH₂CH(CH₂CH₃)(CH₂)₃CH₃, -CH(CH₃)(CH₂)₉CH₃, CH(CH₃)(CH₂)₁₀CH₃, -CH(CH₃)(CH₂)₁₁CH₃, -CH(CH₃)(CH₂)₁₂CH₃, -CH(CH₃)(CH₂)₁₃CH₃, -CH(CH₃)(CH₂)₁₄CH₃, -CH(CH₃)(CH₂)₁₅CH₃, -CH(CH₃)(CH₂)₁₆CH₃, -CH(CH₃)(CH₂)₁₇CH₃, -CH(CH₃)(CH₂)₁₈CH₃, -CH(CH₃)(CH₂)₁₉CH₃, -CH(CH₃)(CH₂)₂₀CH₃, and -CH(CH₃)(CH₂)₂₁CH₃.

Specific examples of a cyclic alkyl group include cyclohexyl, 2,3-dimethylcyclohexyl, 2,5-dimethylcyclohexyl, 2,6-dimethylcyclohexyl, 3,4-dimethylcyclohexyl, 3,5-dimethylcyclohexyl, 2-ethylcyclohexyl, 4-ethylcyclohexyl, 4-isopropylcyclohexyl, 1-methylcyclohexyl, 2-methylcyclohexyl, 3-methylcyclohexyl, 4-methylcyclohexyl, 2-isopropyl-5-methylcyclohexyl, 2-propylcyclohexyl, 4-propylcyclohexyl, 3,3,5-trimethylcyclohexyl, 4-t-butylcyclohexyl, 4-butylcyclohexyl, 4-pentylcyclohexyl, 2-cyclohexylcyclohexyl, 4-cyclohexylcyclohexyl, cycloheptyl, cyclooctylcyclodedecyl and cyclopentadecyl.

Specific examples of an alkyl group having an etheric oxygen atom include -(CH₂CH₂O)αCH₃ (α is an integer of from 3 to 11), -(CH₂CH₂CH₂O)αCH₃ (α is an integer of from 1 to 5), -(CH₂CH₂CH₂CH₂O)αCH₃ (α is an integer of from 1 to 5), -(CH₂CH₂O)αCH₂CH₃ (α is an integer of from 2 to 11), -(CH₂CH₂O)_{α}C(CH₃)₃ (α is an integer of from 1 to 10), -(CH₂CH₂O)α(CH₂)₂CH₃ (α is an integer of from 1 to 10), -(CH₂CH₂O)αCH(CH₃)₂ (α is an integer of from 1 to 10), -(CH₂CH₂O)α(CH₂)₃CH₃ (α is an integer of from 1 to 10), -(CH₂CH₂O)αCH₂CH(CH₃)₂ (α is an integer of from 1 to 10), -(CH₂CH₂O)α(CH₂)₄CH₃ (α is an integer of from 1 to 9), -(CH₂CH₂O)α(CH₂)₅CH₃ (α is an integer of from 1 to 9), -(CH₂CH₂O)α(CH₂)₆CH₃ (α is an integer of from 1 to 8), -(CH₂CH₂O)α(CH₂)₇CH₃ (α is an integer of from 1 to 8), -(CH₂CH₂O)_{α}(CH₂)₈CH₃ (α is an integer of from 1 to 7), -(CH₂CH₂O)_{α}(CH₂)₉CH₃ (α is from 1 to 7), -(CH₂CH₂O)_{α}(CH₂)₁₀CH₃ (α is an integer of from 1 to 6), -(CH₂CH₂O)_{α}(CH₂)₁₁CH₃ (α is from 1 to 6), -(CH₂CH₂O)_{α}(CH₂)₁₂CH₃ (α is an integer of from 1 to 5), -(CH₂CH₂O)_{α}(CH₂)₁₃CH₃ (α is from 1 to 5), -(CH₂CH₂O)_{α}(CH₂)₁₄CH₃ (α is an integer of from 1 to 4), -(CH₂CH₂O)_{α}(CH₂)₁₅CH₃ (α is an integer of from 1 to 4), -(CH₂CH₂O)_{α}(CH₂)₁₆CH₃ (α is an integer of from 1 to 3), -(CH₂CH₂O)_{α}(CH₂)₁₇CH₃ (α is an integer of from 1 to 3), -(CH₂CH₂O)_{α}(CH₂)₁₈CH₃ (α is an integer of from 1 to 2), -(CH₂CH₂O)_{α}(CH₂)₁₉CH₃ (α is an integer of from 1 to 2), -CH₂CH₂O(CH₂)₂₀CH₃, and -CH₂CH₂O(CH₂)₂₁CH₃.

The number of carbon atoms of the Rn group is from 6 to 24, preferably from 7 to 20, particularly preferably from 8 to 18. When the number of carbon atoms of the Rn group is at least the lower limit of the above range, sufficient water repellency can be imparted to the surface of an obtainable cured film. When it is at most the upper limit of the above range, compatibility between a monomer (c1m) having an Rn group mentioned hereinafter and another monomer tends to be favorable when the monomer (c1m) having an Rn group and said another monomer are copolymerized to produce the compound (C).

The number average molecular weight (Mn) of the compound (C) is higher than 3,000 and at most 50,000, preferably from 3,500 to 45,000, particularly preferably from 4,000 to 40,000. When the number average molecular weight (Mn) is at least the lower limit of the above range, at the time of formation of a cured film, the compound (C) sufficiently moves to the surface of the film of the curable composition, whereby water repellency may effectively be imparted to the surface of the cured film. When it is at most the upper limit of the above range, solubility in the curable composition tends to be favorable, and a film of the curable composition without defects can be formed.

The compound (C) is preferably a copolymer having the following units (c1) and units (c2).

Unit (c1): a unit having a C₆₋₂₄ alkyl group which may have an etheric oxygen atom between carbon atoms, and having no fluorine atom nor crosslinkable functional group.

Unit (c2): a unit having a crosslinkable functional group and having no fluorine atom.

The units (c1) are preferably formed by polymerizing a monomer (c1m) having an Rn group and a polymerizable group (a group of the same type as the crosslinkable functional group). Otherwise, units (c1) having an Rn group may be formed by a modification method of reacting a compound having an Rn group with a polymer having reactive functional groups.

In a case where the units (c1) are to be formed by polymerization of the monomer (c1m), the units (c1) do not have a crosslinkable functional group since the polymerizable group of the monomer (c1m) is lost by polymerization.

The polymerizable group is preferably a vinyl(oxy) group, an allyl(oxy) group or a (meth)acryloyl(oxy) group, more preferably a vinyl group or a (meth)acryloyloxy group, particularly preferably a (meth)acryloyloxy group.

Now, the monomer (c1m) will be described.

The monomer (c1m) is preferably a derivative (derivative having a polymerizable group) of e.g. a monool having an Rn group, a monoepoxide having an Rn group, a monocarboxylic acid having an Rn group, a monosulfonic acid having an Rn group, or the like, particularly preferably a derivative of a monool having an Rn group.

The monool having an Rn group is preferably a monool represented by HO-Rn.

The monomer (c1m) is particularly preferably a compound having the Rn group and the polymerizable group bonded by a single bond or a bivalent organic group.

In a case where the Rn group and the polymerizable group are bonded by a single bond, the polymerizable group is a polymerizable group having an oxygen atom at the bond terminal, and the oxygen atom is an oxygen atom of an ether bond, an oxygen atom on the alcohol residue side of an ester bond, or the like. This oxygen atom is an oxygen atom derived from a monool having an Rn group. In a case where the Rn group and the polymerizable group are bonded by a single bond, the polymerizable group is particularly preferably a (meth)acryloyloxy group.

In a case where the Rn group and the polymerizable group are bonded by a bivalent organic group, the organic group is a bivalent organic group having an oxygen atom on the bond terminal on the Rn group side. This oxygen atom is an oxygen atom of an ether bond, an oxygen atom on the alcohol residue side of an ester bond, or the like. This oxygen atom is an oxygen atom derived from a monool having an Rn group. In the case of the bivalent organic group, the number of carbon atoms is preferably at most 25, and is preferably at most 12 when the organic group has one aromatic ring, at most 18 when it has two aromatic rings, or at most 6 when it contains no aromatic ring.

The monomer (c1m) is particularly preferably a monomer represented by the following formula (c1m-1) having the Rn group and a (meth)acryloyloxy group as the polymerizable group bonded by a single bond.

CH₂=CX-COO-Rn (c1m-1)

wherein X is a hydrogen atom or a methyl group, and Rn is a C₆₋₂₄ alkyl group which may have an etheric oxygen atom between carbon atoms.

Specific examples of the monomer (c1m-1) include CH₂=C(CH₃)COO(CH₂)₁₇CH₃, CH₂=CH-COO-(CH₂)₁₇CH₃, CH₂=C(CH₃)-COO-(CH₂)₂₃CH₃, CH₂=C(CH₃)-COO-(CH₂CH₂CH₂CH₂O)₂CH₃, and CH₂=CH-COO-(CH₂CH₂CH₂CH₂O)₂CH₃.

The monomer (c1m) other than the above may, for example, be a reaction product of a monoepoxide having an Rn group and (meth)acrylic acid, a reaction product of a monocarboxylic acid having an Rn group and a hydroxyalkyl (meth)acrylate, or a reaction product of a monosulfonic acid having an Rn group and a hydroxyalkyl (meth)acrylate. For example, by reaction of a compound having an alkyl group and a glycidyl group with (meth)acrylic acid, a compound having a hydroxyalkyl group and a (meth)acryloyloxy group bonded can be obtained.

The proportion of the units (c1) in the compound (C) is preferably from 10 to 90 mass%, more preferably from 15 to 90 mass%, particularly preferably from 20 to 90 mass%. When it is at least the lower limit of the above range, the surface of an obtainable cured film is excellent in the water repellency, and when it is at most the upper limit of the above range, an obtainable curable composition is readily dissolved in a solvent.

The proportion (ratio of charge) of the monomer (c1) which gives the units (c1) based on the compounds (100 mass%) to be used for preparation of the compound (C) is also the same as the above proportion.

The unit (c2) has a crosslinkable functional group and has no fluorine atom. The number of the functional group in the unit (c2) is preferably 1. The crosslinkable functional group of the unit (c2) is particularly preferably a (meth)acryloyl group or a (meth)acryloyloxy group. As described above, the crosslinkable functional groups of the compound (B) and the crosslinkable functional groups of the compound (C) which coexist in the curable composition may be the same or different.

The units (c2) are usually produced by polymerization of a monomer having a polymerizable group and introduction of the crosslinkable functional groups into the obtained polymer. The crosslinkable functional groups of the units (c2) are introduced after formation of the polymer since the polymerizable group of the monomer is lost by polymerization.

This method may be carried out optionally by a known method. Specifically, a monomer having a reactive functional group and a polymerizable group (hereinafter sometimes referred to as a monomer (c4m)) is copolymerized to produce a copolymer having a reactive functional group, and the copolymer is reacted with a compound having a second reactive functional group which is to be reacted with and bonded to the reactive functional group of the obtained copolymer and having a crosslinkable functional group (hereinafter sometimes referred to as compound (c2c)) to produce the compound (C). In this case, the unit (c2) is a unit formed by bonding of the unit (c4) formed by polymerization of the monomer (c4m) and the compound (c2c).

Specifically, the following methods may, for example, be mentioned.
(i) A monomer having a hydroxy group and a polymerizable group as the monomer (c4m) is copolymerized to obtain a copolymer, with which an acid anhydride having a crosslinkable functional group as the compound (c2c) is reacted.
(ii) A monomer having a hydroxy group and a polymerizable group as the monomer (c4m) is copolymerized to obtain a copolymer, with which a compound having an isocyanate group and a crosslinkable functional group as the compound (c2c) is reacted.
(iii) A monomer having a hydroxy group and a polymerizable group as the monomer (c4m) is copolymerized to obtain a copolymer, with which a compound having an acyl chloride group and a crosslinkable functional group as the compound (c2c) is reacted.
(iv) An acid anhydride having a polymerizable group as the monomer (c4m) is copolymerized to obtain a copolymer, with which a compound having a hydroxy group and a crosslinkable functional group as the compound (c2c) is reacted.
(v) A monomer having a carboxy group and a polymerizable group as the monomer (c4m) is copolymerized to obtain a copolymer, with which a compound having an epoxy group and a crosslinkable functional group as the compound (c2c) is reacted.
(vi) A monomer having an epoxy group and a polymerizable group as the monomer (c4m) is copolymerized to obtain a copolymer, with which a compound having a carboxy group and a crosslinkable functional group as the compound (c2c) is reacted.

In a case where the compound (c2c) is reacted with a copolymer having units (c4) in such a manner, substantially all the reactive functional groups of the copolymer may be reacted, or some of the reactive functional groups of the copolymer may be reacted. In the latter case, the obtained compound (C) has units (c4) formed by polymerization of the monomer (c4m). The compound (C) to be used for the curable composition may have such units (c4). Further, in a case where the reactive functional group of the unit (c4) may adversely affect the curable composition, the reactive functional group of the unit (c4) may be reacted with a compound having a second reactive functional group which is to be reacted with and bonded to the reactive functional group of the copolymer and having no crosslinkable functional group, to convert the reactive functional group into an inert group.

Further, the units (c4) remaining in the compound (C) and units having the above inert group derived from the units (c4) are considered as the after-mentioned optional units (c3).

The monomer having a hydroxy group and a polymerizable group in the above (i), (ii) and (iii) and the compound having a hydroxy group and a crosslinkable functional group in (iv) may, for example, be 2-hydroxyethyl (meth)acrylate or 4-hydroxybutyl (meth)acrylate.

Specific examples of the acid anhydride having a crosslinkable functional group in the above (i) and the acid anhydride having a polymerizable group in (iv) include maleic anhydride, itaconic anhydride, citraconic anhydride and phthalic anhydride.

Specific examples of the compound having an isocyanate group and a crosslinkable functional group in the above (ii) include 2-(meth)acryloyloxyethyl isocyanate and 1,1-bis(acryloyloxymethyl)ethyl isocyanate.

Specific examples of the compound having an acyl chloride group and a crosslinkable functional group in the above (iii) include (meth)acryloyl chloride and 3-butenoyl chloride.

Specific examples of the monomer having a carboxy group and a polymerizable group in the above (v) and the compound having a carboxy group and a crosslinkable functional group in (vi) include (meth)acrylic acid.

Specific examples of the compound having an epoxy group and a crosslinkable functional group in the above (v) and the monomer having an epoxy group and a polymerizable group in (vi) include glycidyl (meth)acrylate and 3,4-epoxycyclohexylmethyl acrylate.

The units (c2) are preferably units formed by the above method (ii) or (iii), more preferably units formed by the method (ii) in view of favorable reactivity with the prepolymer (A). Particularly preferred are units formed by reacting a copolymer obtained by copolymerizing 2-hydroxyethyl (meth)acrylate as a monomer having a hydroxy group and a polymerizable group, and 2-(meth)acryloyloxyethyl isocyanate.

The proportion of the units (c2) in the compound (C) is preferably from 1 to 90 mass%, more preferably from 1 to 80 mass%, particularly preferably from 5 to 80 mass%. When it is at least the lower limit of the above range, the reactivity with the prepolymer (A) and the compound (B) tends to be good, and when it is at most the upper limit of the above range, the surface of the resulting cured film will be excellent in the water repellency.

Further, the total proportion (ratio of charge) of the monomer (c4m) and the compound (c2c) which give the units (c2) based on the compounds (100 mass%) to be used for preparation of the compound (C) is also the same as the above proportion.

In a case where the compound (C) is a copolymer, it may have units (c3) other than the units (c1) and the units (c2) as the case requires within a range not to impair the effect to improve water repellency. As described above, in a case where the compound (C) has units (c4) or units derived from the units (c4) and having no crosslinkable functional group, such units are regarded as units (c3).

The units (c3) are preferably introduced to the compound (C) by polymerizing the monomer (c3m). Otherwise, they are also preferably introduced to the polymer by a modification method of properly reacting a compound with the compound (C) having reactive functional groups.

The monomer (c3m) may, for example, be the above monomer (c4m) or a hydrocarbon olefin, a vinyl ether, an isopropenyl ether, an allyl ether, a vinyl ester, an allyl ester, a (meth)acrylic acid ester, a (meth)acrylamide, an aromatic vinyl compound, a chloroolefin or a conjugated diene. Such compounds may have a functional group, and the functional group may, for example, be a hydroxy group, a carbonyl group or an alkoxy group. Such compounds may be used alone or in combination of two or more.

Specific examples of the monomer (c3m) to give the units (c3) include acrylic acid, methacrylic acid, methyl (meth)acrylate, ethyl (meth)acrylate, n-propyl (meth)acrylate, isopropyl (meth)acrylate, n-butyl (meth)acrylate, isobutyl (meth)acrylate, sec-butyl (meth)acrylate, t-butyl (meth)acrylate, n-pentyl (meth)acrylate, 3-methylbutyl (meth)acrylate, n-hexyl (meth)acrylate, 2-ethyl-n-hexyl (meth)acrylate, n-octyl (meth)acrylate, cyclohexyl (meth)acrylate, isobornyl (meth)acrylate, (1,1-dimethyl-3-oxybutyl) (meth)acrylate, 2-acetoacetoxyethyl (meth)acrylate, 2-methoxyethyl (meth)acrylate, 2-ethoxyethyl (meth)acrylate, (meth)acrylamide, N-vinylacetamide, N-vinylformamide, N-(1,1-dimethyl-3-oxobutyl) (meth)acrylamide, N-methoxymethyl (meth)acrylamide, and N,N-bis(methoxymethyl) (meth)acrylamide. In view of availability, preferred is acrylic acid, methacrylic acid, cyclohexyl (meth)acrylate or isobornyl (meth)acrylate.

The proportion of the units (c3) in the compound (C) is preferably at most 70 mass%, more preferably at most 50 mass%, particularly preferably at most 20 mass%. The lower limit is preferably 0 mass%. When the proportion of the units (c3) is within the above range, the water repellency of the surface of the cured film and the curing properties of the curable composition tend to be good.

Further, the proportion (ratio of charge) of the monomer (c3) which gives the units (c3) based on all the monomers (100 mass%) to be used for preparation of the compound (C) is also the same as the above proportion.

As the units in the compound (C), preferred is the following combination.

A combination of units (c1 m-1) as the units (c1) and units formed by the above method (ii) as the units (c2).

The mass ratio of units in the compound (C) is preferably such that units (c1): units (c2): units (c3) = 10 to 90:1 to 90:0 to 70, more preferably 15 to 90:1 to 80:0 to 50, particularly preferably 20 to 90:5 to 80:0 to 20.

Preparation of the compound (C) is carried out preferably in a solvent. The solvent may, for example, be an alcohol such as ethanol, 1-propanol, 2-propanol, 1-butanol or ethylene glycol; a ketone such as acetone, methyl ethyl ketone, methyl isobutyl ketone or cyclohexanone; a cellosolve such as 2-methoxyethanol, 2-ethoxyethanol or 2-butoxyethanol; a carbitol such as 2-(2-methoxyethoxy)ethanol, 2-(2-ethoxyethoxy)ethanol or 2-(2-butoxyethoxy)ethanol; an ester such as methyl acetate, ethyl acetate, n-butyl acetate, ethyl lactate, n-butyl lactate, ethylene glycol monomethyl ether acetate, propylene glycol monomethyl ether acetate, ethylene glycol diacetate or glycerin triacetate; or an ether such as diethylene glycol dimethyl ether or diethylene glycol methyl ethyl ether. They may be used alone or in combination of two or more.

Further, a polymerization initiator is preferably used. The polymerization initiator may, for example, be a known organic peroxide, inorganic peroxide or azo compound. The organic peroxide or the inorganic peroxide may be used as a redox catalyst as combined with a reducing agent. Such polymerization initiators may be used alone or in combination of two or more.

The organic peroxide may, for example, be benzoyl peroxide, lauroyl peroxide, isobutylyl peroxide, t-butyl hydroperoxide or t-butyl-α-cumyl peroxide.

The inorganic peroxide may, for example, be ammonium persulfate, sodium persulfate, potassium persulfate, hydrogen peroxide or a percarbonate.

The azo compound may, for example, be 2,2'-azobisisobutylonitrile, 1,1-azobis(cyclohexane-1-carbonitrile), 2,2'-azobis(2,4-dimethylvaleronitrile), 2,2'-azobis(4-methoxy-2,4-dimethylvaleronitrile), dimethyl 2,2'-azobisisobutyrate or 2,2'-azobis(2-amidinopropane)dihydrochloride.

As the case requires, a chain transfer agent such as a mercaptan or an alkyl halide may be preferably used.

The mercaptan may, for example, be n-butyl mercaptan, n-dodecyl mercaptan, t-butyl mercaptan, ethyl thioglycolate, 2-ethylhexyl thioglycolate or 2-mercaptoethanol. The alkyl halide may, for example, be chloroform, carbon tetrachloride or carbon tetrabromide. They may be used alone or in combination of two or more.

As the case requires, a known polymerization inhibitor may be incorporated. The polymerization inhibitor may, for example, be 2,6-di-t-butyl-p-cresol.

The above solvent may be used also in a case where the obtained copolymer is modified. However, a solvent which reacts with the compound (c2c) cannot be used. Production of the copolymer is carried out in the solvent, and then the compound (c2c) is added and reacted to obtain the compound (C).

Further, modification may be carried out in the presence of a catalyst or a neutralizing agent. For example, in a case where a copolymer having hydroxy groups is reacted with a compound having an isocyanate group and a crosslinkable functional group, e.g. a tin compound may be used as the catalyst. The tin compound may, for example, be dibutyltin dilaurate, dibutyltin di(maleic acid monoester), dioctyltin dilaurate, dioctyltin di(maleic acid monoester) or dibutyltin diacetate. They may be used alone or in combination of two or more.

In the case where a copolymer having hydroxy groups is reacted with a compound having an acyl chloride group and a crosslinkable functional group, a basic catalyst may be used. The basic catalyst may, for example, be triethylamine, pyridine, dimethylaniline or tetramethylurea. They may be used alone or in combination of two or more.

The content of the compound (C) contained in the curable composition is preferably from 0.1 to 20 parts by mass, particularly preferably from 0.2 to 15 parts by mass based on the total amount (100 parts by mass) of the prepolymer (A) and the compound (B). When the content of the compound (C) is at least the lower limit of the above range, the resulting cured film will be excellent in the water resistance. When it is at most the upper limit of the above range, a homogeneous cured film will be obtained.

### (Radical polymerization initiator (D))

### <Thermal polymerization initiator (D1)>

As the thermal polymerization initiator (D1), a known initiator may be used. Specific examples include azobisisobutyronitrile, benzoyl peroxide, tert-butyl hydroperoxide, cumene hydroperoxide, di-tert-butyl peroxide and dicumyl peroxide. In view of the decomposition temperature, preferred is azobisisobutyronitrile or benzoyl peroxide.

The thermal polymerization initiator may be used alone or in combination of two or more.

The content of the thermal polymerization initiator (D1) in the curable composition is preferably from 1 to 20 parts by mass, particularly preferably from 5 to 15 parts by mass based on the total amount (100 parts by mass) of the prepolymer (A) and the compound (B). When it is at least the lower limit of the above range, the curable composition can sufficiently be cured even at room temperature, and the resulting cured film will be excellent in the solvent resistance. When it is at most the upper limit of the above range, storage stability of the curable composition tends to be good.

### <Photopolymerization initiator (D2)>

As the photopolymerization initiator (D2), an initiator known for a photocurable composition may be used. Specific examples include oxime ester derivatives such as 1,2-octanedione, 1-[4-(phenylthio)-, 2-(o-benzoyloxime)] (for example, tradename: IRGACURE OXE01), ethanone, 1-[9-ethyl-6-(2-methylbenzoyl)-9H-carbazol-3-yl]-, 1-(o-acetyloxime) (for example, tradename: IRGACURE OXE02); α-aminoalkylphenone compounds such as IRGACURE 369 (tradename) and IRGACURE 907 (tradename); and acylphosphine oxide compounds such as DAROCUR TPO (tradename) (each manufactured by Ciba Specialty Chemicals). In view of reactivity of radicals generated, preferred is IRGACURE OXE01 or IRGACURE OXE02.

The photopolymerization initiator (D2) may be used alone or in combination of two or more.

The content of the photopolymerization initiator (D2) in the curable composition is preferably from 1 to 20 parts by mass, particularly preferably from 3 to 15 parts by mass based on the total amount (100 parts by mass) of the prepolymer (A) and the compound (B). When it is at least the lower limit of the above range, the curable composition can sufficiently be cured even at room temperature, and the resulting cured film will be excellent in the solvent resistance. When it is at most the upper limit of the above range, the storage stability of the curable composition tends to be good.

### (Additives)

- In the curable composition, as the case requires, additives selected from additives known in the coating field such as a stabilizer such as an ultraviolet absorber, an antioxidant or a thermal polymerization inhibitor; a surfactant such as a leveling agent, a defoaming agent, an anti-settling agent or a dispersing agent; a plasticizer; and a thickener may be incorporated within a range not to impair the effects of the present invention.

Further, in a case where the cured film is a material which is not removed in the production process and remains as a member which functions in a final product (hereinafter sometimes referred to as remaining material), for example, an interlayer insulation film, an adhesion-improving agent such as a silane coupling agent may be added to the curable composition. When an adhesion-improving agent is contained in the curable composition, adhesion between a cured film of the curable composition and a layer adjacent thereto is improved, such being preferred. Further, adhesion may be improved also by a method of preliminarily applying an adhesion-improving agent to the adjacent layer.

The content of the additives in the curable composition is preferably from 0.0001 to 30 parts by mass, more preferably from 0.0001 to 20 parts by mass, particularly preferably from 0.0001 to 10 parts by mass based on the total amount (100 parts by mass) of the prepolymer (A) and the compound (B).

### (Preferred combination)

As the curable composition of the present invention, preferred is the following combination.

A curable composition comprising
prepolymer (A): at least one member among a fluorinated polyarylene ether prepolymer obtained by subjecting perfluorobiphenyl, 1,3,5-trihydroxybenzene and pentafluorophenyl acetylene to dehydrohalogenation reaction; a fluorinated polyarylene ether prepolymer obtained by subjecting perfluorobiphenyl, 1,1,1-tris(4-hydroxyphenyl)ethane and pentafluorostyrene to dehydrohalogenation reaction; and a fluorinated polyarylene ether prepolymer obtained by subjecting perfluorobiphenyl, 1,3,5-trihydroxybenzene and acetoxystyrene to dehydrohalogenation reaction; in an amount of from 40 to 90 parts by mass based on the total amount (100 parts by mass) of the prepolymer (A) and the compound (B),
compound (B): at least one member selected from the group consisting of ditrimethylolpropane tetraacrylate, triacrylate of ε-caprolactone-modified ethoxylated isocyanuric acid, trimethylolpropane triacrylate and tricyclodecane dimethanol diacrylate, in an amount of from 10 to 80 parts by mass based on the total amount (100 parts by mass) of the prepolymer (A) and the compound (B),
compound (C): a copolymer obtained by reacting a copolymer obtained by copolymerizing the monomer (c1m-1) as the monomer (c1m) having an Rn group which gives the units (c1) and 2-hydroxyethyl (meth)acrylate as the monomer (c4m), and 2-acryloyloxyethyl isocyanate as the compound (c2c), in an amount of from 0.1 to 20 parts by mass based on the total amount (100 parts by mass) of the prepolymer (A) and the compound (B), and
thermal polymerization initiator (D1) or photopolymerization initiator (D2): at least one thermal polymerization initiator (D1) selected from the group consisting of benzoyl peroxide and 2,2'-azobisisobutyronitrile or at least one photopolymerization initiator (D2) selected from the group consisting of 1,2-octanedione, 1-[4-(phenylthio)-,2-(o-benzoyloxime)] and ethanone, 1-[9-ethyl-6-(2-methylbenzoyl)-9H-carbazol-3-yl]-, 1-(o-acetyloxime), in an amount of from 3 to 10 parts by mass based on the total amount (100 parts by mass) of the prepolymer (A) and the compound (B).

The curable composition of the present invention is produced by mixing all the components to be contained in the curable composition. The mixing temperature is preferably room temperature (20 to 25°C).

### [Coating composition]

The coating composition of the present invention contains the curable composition and a solvent. By containing a solvent, sufficient application to a substrate will be possible.

By applying the coating composition to a substrate and removing the solvent, a film of the curable composition of the present invention is formed. Usually, removal of the solvent is carried out by evaporating the solvent from the film of the coating composition. Accordingly, the boiling point of the solvent is preferably lower than the boiling points of the respective components constituting the curable composition. The component having the lowest boiling point among the components of the curable composition is usually the compound (B), and accordingly, the solvent is preferably a solvent having a boiling point lower than the boiling point of the compound (B). On the contrary, the compound (B) is preferably a compound having a boiling point sufficiently higher than the solvent to be used.

In a case where the curable composition of the present invention is a liquid composition having a sufficiently low viscosity by itself, the curable composition itself of the present invention containing no solvent may be applied.

The solvent may be a known solvent. Specific examples include polypropylene glycol monomethyl ether acetate (hereinafter sometimes referred to as PGMEA), mesitylene, N,N-dimethylacetamide, cyclohexanone and tetrahydrofuran. Among them, preferred is at least one member selected from the group consisting of PGMEA and cyclohexanone.

The solvents may be used alone or in combination of two or more.

The content of the solvent in the coating composition is preferably from 100 to 5,000 parts by mass, particularly preferably from 100 to 3,000 parts by mass based on the total amount (100 parts by mass) of the prepolymer (A) and the compound (B).

The preferred combination of the coating composition of the present invention is a coating composition comprising the above preferred combination of the curable composition, and a solvent in an amount of from 100 to 3,000 parts by mass based on the total amount (100 parts by mass) of the prepolymer (A) and the compound (B).

### [Method for producing cured film]

The cured film is formed by a method of forming a film of the curable composition on a substrate and curing the film. "Forming a film of the curable composition on a substrate" includes both a state where the film of the curable composition is directly formed on the substrate and a state where an optional layer is formed on the substrate and the film of the curable composition is formed on the layer. Further, in a case where the coating composition is used, a state where the film of the coating composition is formed on the substrate and then the solvent is removed to form a film of the curable composition is included. Further, in a case where the curable resin composition of the present invention is a liquid curable composition containing no solvent, a state where the curable composition is applied to form a film of the curable composition is included.

The thickness of the cured film is not particularly limited and is optionally set depending upon the application. For example, it is preferably from about 0.1 to 100 µm, particularly preferably from 0.2 to 50 µm.

Formation of the film of the curable composition directly on the substrate or formation of the film of the coating composition on the substrate may be carried out by a known coating method. For example, a spin coating method, a dip coating method, a spray coating method, a die coating method, a bar coating method, a doctor coating method, an extrusion coating method, a scan coating method, a brush coating method, a potting method, inkjet or printing may, for example, be mentioned. In view of uniformity of the film thickness, preferred is a spin coating method or a scan coating method.

In a case where curing is conducted by heat-curing, a film of the curable composition is formed on the substrate and heated (curing step) to obtain a cured film. Before the curing step, heating (prebaking) may be carried out.

In a case where curing is conducted by photocuring, a film of the curable composition is formed on the substrate and as the case requires, heating (prebaking) is carried out, and then light irradiation (exposure) is carried out and as the case requires, heating (curing step) is carried out to obtain a cured film. In view of the cost, preferred is a method of forming a film of the curable composition on the substrate, followed by light irradiation (exposure) to obtain a cured film. More preferred is a method of forming a film of the coating composition on a substrate, removing the solvent by heating (prebaking) to form a film of the curable composition, followed by light irradiation (exposure) to obtain a cured film. Further, a photomask may be used at the time of exposure.

The light to be applied is not particularly limited so long as it is light having a wavelength to which the photopolymerization initiator (D2) contained in the curable composition is sensitive. Usually, light used for curing is ultraviolet light, but is not limited thereto.

In a case where microfabrication by photolithography is carried out, by selectively applying light (exposure), the irradiated portion (exposed portion) is cured. Accordingly, by carrying out development (a step of dissolving or dispersing the non-exposed portion in a solvent and removing it) after exposure, the non-exposed portion is removed and the remaining solvent at the cured portion is removed to obtain a microfabricated cured film. As the case requires, heating (curing step) may be carried out after development. In such a case, the remaining solvent may be removed by heating (curing step). Further, a heating step (post-exposure baking) may be carried out as the case requires after exposure or before development.

In the present invention, curing of the cured film may be carried out at a low heating temperature of at most 250°C. In such a case, if heating is carried out twice or more, for example, in a case of carrying out prebaking and/or post-exposure baking and the curing step, the heating temperature in every heating is at most 250°C. If the heat resistant temperature of the substrate is lower than 250°C, the heating temperature is at most the heat resistant temperature of the substrate.

In the present invention, a heating temperature of at most 250°C means that the temperature of an article to be heated does not exceed 250°C. Specifically, the temperature of a heating apparatus such as a hot plate or an oven is set to be at most 250°C.

In the method for producing a cured film, prebaking is carried out for the purpose of removing the solvent when the coating composition is used, and is carried out at a relatively low heating temperature. The heating temperature in prebaking is not particularly limited and is preferably, for example, from 40 to 100°C.

The curing step and the post-exposure baking is carried out for the purpose of further curing the film, and is carried out at a relatively high heating temperature. The heating temperature in the curing step and the post-exposure baking is preferably at least 80°C, particularly preferably at least 100°C. If it is lower than such a temperature, the effect by carrying out the curing step or the post-exposure baking tends to be insufficient. Further, as shown in the after-mentioned Examples, from the curable composition of the present invention, a cured film having favorable solvent resistance can be obtained even if the heating temperature of the curing step or the post-exposure baking is from 100 to 150°C. The heating temperature is preferably lower, whereby the substrate is less likely to be damaged.

Accordingly, heating in production of the cured film is carried out preferably at a heating temperature of at most 200°C. In a case where heating is carried out twice or more, the heating temperature in each heating is at most 200°C. If the heat resistant temperature of the substrate is lower than 200°C, the heating temperature is at most the heat resistant temperature of the substrate. Substantially, the temperature of the heating apparatus such as a hot plate or an oven is set to be at most 200°C.

Production of the cured film is carried out preferably by using the coating composition, at a temperature of at most 250°C in every heating for formation of the cured film. Further, even in the case of photocuring, heating is required e.g. for removal of the solvent, and the heating temperature in such a case is preferably at most 250°C. Accordingly, the method for producing a cured film is preferably a method of forming a film of the coating composition on a substrate, and heat-curing or photocuring the curable composition by heating once or more to produce a cured film, and the heating temperature is preferably at most 250°C in every heating.

The substrate to be used in the present invention may, for example, be plastic, glass or silicon. For example, a plastic such as polycarbonate, polyethylene terephthalate, polyethylene naphthalate, polyether sulfone or polyimide is preferably used, in view of excellent mechanical flexibility.

### [Semiconductor device]

The cured film of the curable composition of the present invention may suitably be used for production of a semiconductor device.

That is, a semiconductor device may suitably be produced by a method of forming a film of the coating composition containing the curable composition of the present invention on a substrate, and heat-curing or photocuring the curable composition by heating once or more to produce a cured film. The first heating after formation of the film of the coating composition is usually to remove the solvent.

Fig. 1 is a diagram schematically illustrating the cross section of a device structure, and illustrates an embodiment of an organic thin film transistor which is one example of the semiconductor device. The organic thin film transistor in Fig. 1 has a cured film obtained by curing the curable composition of the present invention as a gate insulation film.

The organic thin film transistor in this example has a substrate 1, and a gate electrode 2, a gate insulation film 3 and an organic semiconductor layer 4 formed in this order on the substrate 1, and further has a source electrode 5 and a drain electrode 6 formed thereon.

Further, there is a variety of device structures of an organic thin film transistor, and the organic thin film transistor is not particularly limited so long as it has a gate insulation film obtainable by curing the curable composition of the present invention.

In Fig. 1, the reference symbol 1 represents a substrate. Its preferred material is the same as the above-described material preferred as a substrate.

The gate electrode 2, the source electrode 5 and the drain electrode 6 are formed by an electric conductor. The electric conductor to be used for such electrodes is not particularly limited, and for example, silicon, doped silicon, platinum, gold, silver, copper, chromium, aluminum, calcium, valium, indium tin oxide, indium zinc oxide, zinc oxide, carbon black, a fullerene, carbon nanotubes, polythiophene, polyethylene dioxithiophene, polystyrene sulfonate, polyaniline, polypyrrole and polyfluorene are preferred. Such electrode materials may be used alone or in combination of a plurality of materials. Further, the materials of the gate electrode 2, the source electrode 5 and the drain electrode 6 may be the same or different.

The method for forming the electrode is not particularly limited, and for example, sputtering, vacuum deposition, spin coating, spray coating, printing or inkjet may, for example, be mentioned.

As the material of the organic semiconductor layer 4, a low molecular weight compound, an oligomer or a polymer may be used, and the material is not particularly limited. The low molecular weight compound may, for example, be pentacene, rubrene, phthalocyanine, perylene, fullerene or a derivative thereof.

The oligomer may, for example, be oligothiophene or a derivative thereof.

The polymer may, for example, be poly-p-phenylene vinylene (PPV), polyfluorene, a fluorene/benzothiadiazole copolymer, a fluorene/triphenylamine copolymer, a fluorene/dithiophene copolymer, polythiophene, polyaniline, polyacetylene, polypyrrole or a derivative thereof.

The method for forming the organic semiconductor layer 4 is not particularly limited. However, the surface of the cured film of the curable composition of the present invention has water repellency and lipophilicity, since the curable composition contains the compound (C), and accordingly the cured film does not repel an organic solvent-based coating liquid containing the material of the organic semiconductor layer 4. Accordingly, it is suitable to form the organic semiconductor layer 4 on the cured film of the curable composition of the present invention by a method of applying an organic solvent-based coating liquid.

Further, as a method for forming the organic semiconductor layer 4, a method may also be employed wherein a layer made of a precursor of an organic semiconductor is formed e.g. by a method of applying a coating liquid as described above, and then the precursor is converted to an organic semiconductor by applying heat or light. As a precursor material capable of being converted, for example, a silylethyne-substituted pentacene or a tetrabicycloporphyrin derivative may be mentioned. Since such a material may be converted to pentacene or a tetrabenzoporphyrin derivative by heating, it may be used as a precursor material of the organic semiconductor layer.

The film thickness of the organic semiconductor layer 4 is not particularly limited, and is preferably from 5 nm to 100 µm, more preferably from 10 nm to 10 µm, particularly preferably from 10 nm to 1 µm.

The gate insulation film 3 may be formed by the above [Method for producing cured film] using the curable composition of the present invention. The film thickness of the gate insulation film 3 comprising a cured film cured by heat or light is not particularly limited, and the thickness t at a portion where no gate electrode 2 is present is preferably from 1 nm to 10 µm, more preferably from 2 nm to 5 µm, particularly preferably from 5 nm to 1 µm. If the film thickness of the gate insulation film 3 is too small, the leakage current is likely to occur between the gate electrode 2 and the source electrode 5, and if the film thickness is too large, the driving voltage tends to increase.

In the organic thin film transistor thus obtainable, by forming the gate insulation film 3 using the curable composition of the present invention, the leakage current is reduced. Since it is possible to make the gate insulation film 3 thin, downsizing of a device can be realized, and the driving voltage of the transistor can be decreased.

Further, in the organic thin film transistor of this example, since the surface of the gate insulation film 3 has favorable water repellency, such effects will be obtained that molecules in the organic semiconductor layer 4 provided on the gate insulation film 3 are likely to be oriented, polar groups to be top sites of a carrier are less likely to be present on the surface, and moisture and the like in the air are less likely to be adsorbed. Accordingly, the electron mobility in the organic thin film transistor will be high, and the stability and the reliability will be improved. Further, in the organic thin film transistor of this example, since the surface of the gate insulation film 3 has favorable lipophilicity, as described above, the organic semiconductor layer 4 may suitably be formed by a method of applying an organic solvent-based coating liquid containing a material of the organic semiconductor layer 4 or a material of a precursor of the organic semiconductor layer 4 to the surface of the gate insulation film 3.

### EXAMPLES

Now, the present invention will be described in further detail with reference to Examples. However, it should be understood that the present invention is by no means restricted to such specific Examples. The evaluation methods are as follows.

### (Contact angle)

The contact angle of the surface of the cured film was measured by a droplet method at 25°C using a contact angle meter (manufactured by Kyowa Interface Science Co., Ltd., tradename: CA-A). In the case of evaluation of the water repellency, about 1 µL of water was dropped on the cured film and the contact angle was measured, and in the case of evaluation of oil repellency, about 1 µL of PGMEA was dropped and the contact angle was measured.

### (Relative dielectric constant)

The relative dielectric constant was measured by CV measurement using a mercury probe (manufactured by SSM, tradename: SSM-495) to obtain the relative dielectric constant at 1 MHz.

### (Coating properties)

With respect to the coating properties of the cured film on the surface, after the cured film is formed, a liquid for evaluation of coating properties was applied by spin coating, and the coating properties were evaluated based on standards ○ (good): the surface of the cured film has affinity with the liquid for evaluation of coating properties, and application was possible, and × (bad): the surface of the cured film repelled the liquid for evaluation of coating properties, and application could not be conducted. As the liquid for evaluation of coating properties, OFPR-800LB-130 (manufactured by TOKYO OHKA KOGYO CO., LTD.) which is a novolac resin type resist was used.

### [Preparation of fluorinated polyarylene prepolymer (A)]

Abbreviations mean the following compounds.
DMAc: N,N-dimethylacetamide
PFB: perfluorobiphenyl

### (Preparation Example 1: Preparation of prepolymer (A1))

In DMAc (6,620 g) solvent, PFB (450 g), pentafluorophenylacetylene (155 g) and 1,3,5-trihydroxybenzene (130 g) were reacted in the presence of powdery molecular sheaves 4A (600 g) and sodium carbonate (600 g) at 60°C for 45 hours to prepare prepolymer (A1). The obtained DMAc solution of prepolymer (A1) was poured into a hydrochloric acid aqueous solution (3.5 mass% aqueous solution) for reprecipitation and purification, followed by vacuum drying to obtain 620 g of powdery prepolymer (A1). The number average molecular weight (Mn) of prepolymer (A1) was 10,000.

### (Preparation Example 2: Preparation of prepolymer (A2))

In DMAc (492 g) solvent, pentafluorostyrene (22 g) and 1,1,1-tris(4-hydroxyphenyl)ethane (33 g) were reacted in the presence of sodium carbonate (51 g) at 60°C for 24 hours, and then a solution having PFB (40 g) dissolved in DMAc (360 g) was added, followed by reaction at 60°C further for 17 hours to prepare prepolymer (A2). The obtained DMAc solution of prepolymer (A2) was poured into a hydrochloric acid aqueous solution (3.5 mass% aqueous solution) for reprecipitation and purification, followed by vacuum drying to obtain 750 g of powdery prepolymer (A2). The number average molecular weight (Mn) of prepolymer (A2) was 10,000.

### (Preparation Example 3: Preparation of prepolymer (A3))

In DMAc (6.2 kg) solvent, PFB (650 g) and 1,3,5-trihydroxybenzene (120 g) were reacted in the presence of potassium carbonate (570 g) at 40°C for 6 hours, and then 4-acetoxystyrene (200 g) was reacted in the presence of a 48 mass% potassium hydroxide aqueous solution (530 g) to prepare prepolymer (A3). The obtained DMAc solution of prepolymer (A3) was poured into a hydrochloric acid aqueous solution (3.5 mass% aqueous solution) for reprecipitation and purification, followed by vacuum drying to obtain 800 g of powdery prepolymer (A3). The number average molecular weight (Mn) of prepolymer (A3) was 10,000.

### [Preparation of compounds (C-1) and (F-1)]

(Monomer (c1m) having C₆₋₂₄ alkyl group (Rn))
   C18MA: CH₂=C(CH₃)COO(CH₂)₁₇CH₃
(Monomer having fluoroalkyl group (Cf))
   C6FMA: CH₂=C(CH₃)COOCH₂CH₂(CF₂)₆F
(Monomer (c4m) having hydroxy group)
   HEMA: 2-hydroxyethyl methacrylate.
(Compound (c2c) having isocyanate group and crosslinkable functional group)
   AOI: 2-acryloyloxyethyl isocyanate.
   MOI: 2-methacryloyloxyethyl isocyanate.
(Chain transfer agent)
   DSH: n-dodecylmercaptan.
(Polymerization initiator)
   V-65: 2,2'-azobis(2,4-dimethylvaleronitrile) (manufactured by Wako Pure Chemical Industries, Ltd., tradename: V-65).
   V-70: 2,2'-azobis(4-methoxy-2,4-dimethylvaleronitrile) (manufactured by Wako Pure Chemical Industries, Ltd., tradename: V-70).
(Catalyst)
   DBTDL: dibutyltin dilaurate.
(Polymerization inhibitor)
   BHT: 2,6-di-t-butyl-p-cresol.

### (Preparation Example 4: Preparation of compound (C-1))

In methyl ethyl ketone (27.6 g) solvent, C18MA (8.0 g) and HEMA (3.1 g) were reacted in the presence of DSH (0.68 g) and V-65 (0.094 g) at 50°C for 24 hours and then at 70°C for 2 hours.

Then, AOI (3.3 g), DBTDL (0.013 g) and BHT (0.17 g) were reacted at 40°C for 24 hours to prepare compound (C-1) as a copolymer. The obtained methyl ethyl ketone solution of compound (C-1) was poured into methanol for reprecipitation and purification, followed by vacuum drying to obtain 11 g of powdery compound (C-1). The number average molecular weight (Mn) of (C-1) was 8,000.

### (Preparation Example 5: Preparation of compound (F-1)): Comparative Example

In acetone (555 g) solvent, C6FMA (120 g) and HEMA (120 g) were reacted in the presence of DSH (16 g) and V-70 (3.6 g) at 40°C for 18 hours to obtain a solution of polymer 4. The obtained acetone solution of polymer 4 was poured into water for reprecipitation and purification, followed by vacuum drying to obtain 230 g of powdery polymer 1.

Then, in acetone (100 g) solvent, polymer 1 (100 g), MOI (60 g), DBTDL (0.4 g) and BHT (3.0 g) were reacted at 30°C for 18 hours to prepare compound (F-1) as a copolymer. The obtained acetone solution of compound (F-1) was poured into water for reprecipitation and purification, followed by vacuum drying to obtain 155 g of powdery compound (F-1) containing fluorine. Of compound (F-1), the fluorine content was 23 mass%, and the number average molecular weight (Mn) was 4,500.

### [Coating composition]

### (Compound (B))

M408: ditrimethylolpropane tetraacrylate (number average molecular weight (Mn): 466).
A9300-1 CL: triacrylate of ε-caprolactone-modified ethoxylated isocyanuric acid (manufactured by Shin-Nakamura Chemical Co., Ltd., "ε-caprolactone-modified tris-(2-acryloxyethyl)isocyanurate", number average molecular weight (Mn): 537).
ATMPT: trimethylolpropane triacrylate (number average molecular weight (Mn): 296).
ADCP: tricyclodecane dimethanol diacrylate (number average molecular weight (Mn): 304).

### (Thermal polymerization initiator (D1))

AIBN: azobisisobutyronitrile
BPO: benzoyl peroxide

### (Photopolymerization initiator (D2))

OXE01: 1,2-octanedione, 1-[4-(phenylthio)-, 2-(o-benzoyloxime)].
OXE02: ethanone, 1-[9-ethyl-6-(2-methylbenzoyl)-9H-carbazol-3-yl]-, 1-(o-acetyloxime).

### (Solvent)

PGMEA: propylene glycol monomethyl ether acetate.

### [Ex. 1 to 6: Heat curing]

Ex. 1 to 5 are Examples of the present invention, and Ex. 6 is a Comparative Example.

The respective components were mixed in a blend ratio as identified in Table 1 at room temperature to obtain a coating composition.

The obtained coating composition was applied to a glass substrate by spin coating at 1,000 revolutions per minute for 30 seconds, followed by heating (prebaking) by a hot plate. The heating conditions were 150°C and 2 minutes. Then, heating (curing step) was carried out in an oven at 150°C for 10 minutes to obtain a cured film having a film thickness of 1 µm. With respect to the obtained cured film, the contact angle and the relative dielectric constant were measured, and the coating properties were evaluated. The results are shown in Table 1.

### [Ex. 7 to 12: Photocuring]

Ex. 7 to 11 are Examples of the present invention, and Ex. 12 is a Comparative Example.

The respective components were mixed in a blend ratio as identified in Table 2 at room temperature to obtain a coating composition.

The obtained coating composition was applied to a glass substrate by spin coating at 1,000 revolutions per minute for 30 seconds, followed by heating (prebaking) by a hot plate. The heating conditions were 60°C and 90 seconds. Then, exposure with an irradiation energy of 200 mJ/cm² was carried out. As exposure, light was applied using an ultraviolet exposure apparatus (manufactured by SUSS, tradename: MA-6) using a high pressure mercury lamp as a light source. Further, with respect to the non-exposed portion, an area of 1/3 of the substrate was shielded using a metal foil or a mask.

Then, heating was carried out at 120°C for 2 minutes (post-exposure baking) by a hot plate. Then, paddle development was carried out using PGMEA for 20 seconds, followed by spin drying at 2,000 revolutions per minute for 30 seconds. Then, heating (curing step) was carried out at 100°C for 5 minutes by a hot plate to obtain a cured film having a film thickness of 1 µm. With respect to the obtained cured film, the contact angle and the relative dielectric constant were measured, and the coating properties were evaluated. The results are shown in Table 2.

**[Table 1]**

| | | | Ex. | | | | | |
|---|---|---|---|---|---|---|---|---|
| | | | 1 | 2 | 3 | 4 | 5 | 6 |
| | Prepolymer (A) | (A1) | 80 | | | | | |
| | | (A2) | | 80 | | | | |
| | | (A3) | | | 80 | 60 | 60 | 60 |
| | Compound (B) | M408 | 20 | 20 | 20 | 40 | | 40 |
| Blend ratio (parts by mass) | | A9300-1 CL | | | | | 30 | |
| | | ATMPT | | | | | 10 | |
| | Compound (C) | (C-1) | 0.5 | 0.5 | 0.5 | 0.5 | 0.5 | |
| | Compound (F-1) | | | | | | | 0.5 |
| | Thermal polymerization initiator (D1) | AIBN | 8 | | 8 | | | |
| | | BPO | | 7 | | 7 | 7 | 7 |
| | Solvent | PGMEA | 250 | 250 | 250 | 250 | 250 | 250 |
| Evaluation | Water contact angle (°) | | 95 | 95 | 95 | 95 | 95 | 97 |
| | PGMEA contact angle (°) | | <10 | <10 | <10 | <10 | <10 | 55 |
| | Relative dielectric constant | | 2.9 | 2.9 | 2.9 | 2.9 | 2.9 | 2.9 |
| | Coating properties | | ○ | ○ | ○ | ○ | ○ | × |

**[Table 2]**

| | | | Ex. | | | | | |
|---|---|---|---|---|---|---|---|---|
| | | | 7 | 8 | 9 | 10 | 11 | 12 |
| | Prepolymer (A) | (A1) | 80 | | | | | |
| | | (A2) | | 80 | | | | |
| | | (A3) | | | 80 | 60 | 60 | 60 |
| Blend ratio (parts by mass) | Compound (B) | ADCP | 20 | 20 | 20 | 40 | | 40 |
| | | ATMPT | | | | | 40 | |
| | Compound (C) | (C-1) | 0.5 | 0.5 | 0.5 | 0.5 | 0.5 | |
| | Compound (F-1) | | | | | | | 0.5 |
| | Photopolymerization initiator (D2) | OXE01 | 10 | | | 10 | 10 | 10 |
| | | OXE02 | | 10 | 10 | | | |
| | Solvent | PGMEA | 250 | 250 | 250 | 250 | 250 | 250 |
| Evaluation | Water contact angle (°) | | 95 | 95 | 95 | 95 | 95 | 97 |
| | PGMEA contact angle (°) | | <10 | <10 | <10 | <10 | <10 | 55 |
| | Relative dielectric constant | | 2.7 | 2.7 | 2.7 | 2.7 | 2.7 | 2.7 |
| | Coating properties | | ○ | ○ | ○ | ○ | ○ | × |

As evident from the results in Tables 1 and 2, although each of the cured films formed in Ex. 1 to 5 and Ex. 7 to 11 had high water repellency with a water contact angle of 95°, its PGMEA contact angle was less than 10°, and thus the surface of the cured film had water repellency and lipophilicity. Since it has lipophilicity, the liquid for evaluation of coating properties could favorably be applied to the cured film, and the cured film had excellent coating properties. Further, it had a low relative dielectric constant and sufficient insulation properties.

Whereas, each of the cured films formed in Ex. 6 and 12, which was formed by using compound (F-1) containing fluorine instead of compound (C-1), had a large PGMEA contact angle and had oil repellency. Accordingly, the cured film repelled the liquid for evaluation of coating properties, and a coating film could not be formed on the cured film.

### INDUSTRIAL APPLICABILITY

The cured film of the curable composition of the present invention is used as a functional film having a function such as electrical insulation, chemical or physical protection, non-adhesiveness of the surface, etc. of a semiconductor device or various electron devices. Specifically, an insulation film of an oxide semiconductor, an interlayer insulation film for a flexible device, a protective film for a flexible device, a gate insulation film for an organic thin-film transistor, a gate insulation film for an oxide thin-film transistor, a capacitor insulation film, a gate insulation film of a memory transistor, a passivation of a semiconductor, a protective film of a semiconductor device, an interlayer insulation film of multilayer interconnection for high density mounting, an insulating layer of an organic electroluminescence device, an insulation film for re-wiring, a cover coating of a flexible copper-clad plate, a solder resist film, a liquid crystal alignment film, a protective film for a color filter, a resin post for e.g. a semiconductor device, and partition walls for e.g. a color filter, etc. may be mentioned. It is particularly useful as an insulation film of a device such as an organic thin film transistor, and the curable composition of the present invention is useful as a material for producing such a functional film.

### REFERENCE SYMBOLS

- 1:: Substrate
- 2:: Gate electrode
- 3:: Gate insulation film
- 4:: Organic semiconductor layer
- 5:: Source electrode
- 6:: Drain electrode

## Claims

1. A curable composition comprising a fluorinated polyarylene prepolymer (A) having crosslinkable functional groups,
a compound (B) having at least two crosslinkable functional groups, having no fluorine atom and having a number average molecular weight of from 140 to 3,000,
a compound (C) having a C₆₋₂₄ alkyl group which may have an etheric oxygen atom between carbon atoms, having crosslinkable functional groups, having no fluorine atom and having a number average molecular weight higher than 3,000 and at most 50,000, and
a radical polymerization initiator (D).

2. The curable composition according to Claim 1, wherein the fluorinated polyarylene prepolymer (A) is a fluorinated polyarylene ether prepolymer having crosslinkable functional groups, obtained by reacting a fluorinated aromatic compound having a fluorine atom bonded to a carbon atom of the aromatic ring, a phenol compound having at least two phenolic hydroxy groups, and an aromatic compound having a crosslinkable functional group and a reactive group capable of being reacted in the presence of a dehydrohalogenating agent, in the presence of a dehydrohalogenating agent.

3. The curable composition according to Claim 1 or 2, wherein the compound (B) is a poly(meth)acrylate of a polyhydric alcohol.

4. The curable composition according to any one of Claims 1 to 3, wherein the compound (C) is a copolymer having the following units (c1) and the following units (c2):
unit (c1): a unit having a C₆₋₂₄ alkyl group which may have an etheric oxygen atom between carbon atoms and having no fluorine atom nor crosslinkable functional group,
unit (c2): a unit having a crosslinkable functional group and having no fluorine atom.

5. The curable composition according to Claim 4, wherein the units (c1) are units formed by polymerization of a monomer represented by the following formula (c1 m-1):
CH₂=CX-COO-Rn (c1m-1)
wherein X is a hydrogen atom or a methyl group, and Rn is a C₆₋₂₄ alkyl group which may have an etheric oxygen atom between carbon atoms.

6. The curable composition according to any one of Claims 1 to 5, wherein each of the crosslinkable functional groups in the prepolymer (A), the compound (B) and the compound (C) which are independent of one another, is a crosslinkable functional group selected from the group consisting of a vinyl(oxy) group, an allyl(oxy) group, an ethynyl group and a (meth)acryloyl(oxy) group.

7. The curable composition according to any one of Claims 1 to 6, wherein the compound (B) is contained in an amount of from 10 to 80 mass% based on the total amount (100 mass%) of the prepolymer (A) and the compound (B).

8. The curable composition according to any one of Claims 1 to 7, wherein the radical polymerization initiator (D) is a thermal polymerization initiator (D1) or a photopolymerization initiator (D2).

9. The curable composition according to any one of Claims 1 to 8, wherein the compound (C) is contained in an amount of from 0.1 to 20 parts by mass based on the total amount (100 mass%) of the prepolymer (A) and the compound (B).

10. A coating composition comprising the curable composition as defined in any one of Claims 1 to 9 and a solvent.

11. A method for producing a cured film, which comprises forming a film of the coating composition as defined in Claim 10 on a substrate, and heat-curing or photocuring the curable composition by a step including at least one heating step to produce a cured film, wherein the heat temperature in every heating step is at most 250°C.

12. A substrate having a cured film of the curable composition as defined in any one of Claims 1 to 9 formed thereon.

13. A semiconductor device having a cured film of the curable composition as defined in any one of Claims 1 to 9.

14. The semiconductor device as defined in Claim 13, which is an organic thin film transistor having the cured film as a functional film.

15. The semiconductor device according to Claim 14, wherein the functional film is a gate insulation film.

## Patentansprüche

1. Härtbare Zusammensetzung, umfassend ein fluoriertes Polyarylenpräpolymer (A) mit vernetzbaren funktionellen Gruppen,
eine Verbindung (B) mit mindestens zwei vernetzbaren funktionellen Gruppen, ohne Fluoratom und mit einem zahlengemittelten Molekulargewicht von 140 bis 3.000,
eine Verbindung (C) mit einer C₆₋₂₄-Alkylgruppe, welche ein etherisches Sauerstoffatom zwischen den Kohlenstoffatomen aufweisen kann, mit vernetzbaren funktionellen Gruppen, ohne Fluoratom und mit einem zahlengemittelten Molekulargewicht von höher als 3.000 und höchstens 50.000 und
einen Radikalpolymerisationsinitiator (D).

2. Härtbare Zusammensetzung nach Anspruch 1, wobei das fluorierte Polyarylenprepolymer (A) ein fluoriertes Polyarylenetherpräpolymer mit vernetzbaren funktionellen Gruppen ist, erhalten durch Umsetzen einer fluorierten aromatischen Verbindung mit einem an ein Kohlenstoffatom des aromatischen Ringes gebundenen Fluoratom, einer Phenolverbindung mit mindestens zwei phenolischen Hydroxygruppen und einer aromatischen Verbindung mit einer vernetzbaren funktionellen Gruppe und einer reaktiven Gruppe, die in der Lage ist, in der Gegenwart eines Dehydrohalogenierungsmittels umgesetzt zu werden, in der Gegenwart eines Dehydrohalogenierungsmittels.

3. Härtbare Zusammensetzung nach Anspruch 1 oder 2, wobei die Verbindung (B) ein Poly(meth)acrylat eines mehrwertigen Alkohols ist.

4. Härtbare Zusammensetzung nach einem der Ansprüche 1 bis 3, wobei die Verbindung (C) ein Copolymer mit den nachstehenden Einheiten (c1) und den nachstehenden Einheiten (c2) ist:
Einheit (c1): eine Einheit mit einer C₆₋₂₄-Alkylgruppe, welche ein etherisches Sauerstoffatom zwischen den Kohlenstoffatomen aufweisen kann, und weder ein Fluoratom noch eine vernetzbare funktionelle Gruppe aufweisend,
Einheit (c2): eine Einheit mit einer vernetzbaren funktionellen Gruppe und ohne Fluoratom.

5. Härtbare Zusammensetzung nach Anspruch 4, wobei die Einheiten (c1) durch Polymerisation eines Monomers, dargestellt durch die nachstehende Formel (c1m-1), gebildete Einheiten sind:
CH₂=CX-COO-Rn (c1 m-1)
wobei X ein Wasserstoffatom oder eine Methylgruppe ist und Rn eine C₆₋₂₄-Alkylgruppe, welche ein etherisches Sauerstoffatom zwischen den Kohlenstoffatomen aufweisen kann, ist.

6. Härtbare Zusammensetzung nach einem der Ansprüche 1 bis 5, wobei jede der vernetzbaren funktionellen Gruppen in dem Präpolymer (A), der Verbindung (B) und der Verbindung (C), welche unabhängig voneinander sind, eine vernetzbare funktionelle Gruppe, ausgewählt aus der Gruppe, bestehend aus einer Vinyl(oxy)gruppe, einer Allyl(oxy)gruppe, einer Ethynylgruppe und einer (Meth)acryloyl(oxy)gruppe, ist.

7. Härtbare Zusammensetzung nach einem der Ansprüche 1 bis 6, wobei die Verbindung (B) in einer Menge von 10 bis 80 Massen-%, bezogen auf die Gesamtmenge (100 Massen-%) des Präpolymers (A) und der Verbindung (B), enthalten ist.

8. Härtbare Zusammensetzung nach einem der Ansprüche 1 bis 7, wobei der Radikalpolymerisationsinitiator (D) ein thermischer Polymerisationsinitiator (D1) oder ein Photopolymerisationsinitiator (D2) ist.

9. Härtbare Zusammensetzung nach einem der Ansprüche 1 bis 8, wobei die Verbindung (C) in einer Menge von 0,1 bis 20 Massenteile, bezogen auf die Gesamtmenge (100 Massen-%) des Präpolymers (A) und der Verbindung (B), enthalten ist.

10. Beschichtungszusammensetzung, umfassend die härtbare Zusammensetzung nach einem der Ansprüche 1 bis 9 und ein Lösungsmittel.

11. Verfahren zur Herstellung eines gehärteten Films, welches das Bilden eines Films der Beschichtungszusammensetzung nach Anspruch 10 auf einem Substrat und das Wärmehärten oder Photohärten der härtbaren Zusammensetzung durch einen Schritt, einschließlich mindestens eines Erwärmungsschritts, zum Herstellen eines gehärteten Films umfasst, wobei die Erwärmungstemperatur in jedem Erwärmungsschritt höchstens 250 °C beträgt.

12. Substrat mit einem darauf gebildeten, gehärteten Film der härtbaren Zusammensetzung nach einem der Ansprüche 1 bis 9.

13. Halbleitervorrichtung mit einem gehärteten Film der härtbaren Zusammensetzung nach einem der Ansprüche 1 bis 9.

14. Halbleitervorrichtung nach Anspruch 13, welche ein organischer Dünnschichttransistor mit dem gehärteten Film als ein funktionaler Film ist.

15. Halbleitervorrichtung nach Anspruch 14, wobei der funktionale Film ein Gate-Isolationsfilm ist.

## Revendications

1. Composition durcissable comprenant un prépolymère de polyarylène fluoré (A) comportant des groupes fonctionnels réticulables,
un composé (B) comportant au moins deux groupes fonctionnels réticulables, ne comportant pas d'atome de fluor et présentant une masse moléculaire moyenne en nombre de 140 à 3 000,
un composé (C) comportant un groupe alkyle en C₆ à C₂₄ pouvant porter un atome d'oxygène d'éther entre des atomes de carbone, comportant des groupes fonctionnels réticulables, ne comportant pas d'atome de fluor et présentant une masse moléculaire moyenne en nombre supérieure à 3 000 et d'au plus 50 000, et
un amorceur de polymérisation radicalaire (D).

2. Composition durcissable selon la revendication 1, dans laquelle le prépolymère de polyarylène fluoré (A) est un prépolymère d'éther de polyarylène fluoré comportant des groupes fonctionnels réticulables, obtenu par réaction d'un composé aromatique fluoré comportant un atome de fluor lié à un atome de carbone du cycle aromatique, d'un composé phénolique comportant au moins deux groupes hydroxy phénoliques, et d'un composé aromatique comportant un groupe fonctionnel réticulable et un groupe réactif capable de réagir en présence d'un agent de déshydrohalogénation, en présence d'un agent de déshydrohalogénation.

3. Composition durcissable selon la revendication 1 ou 2, dans laquelle le composé (B) est un poly(méth)acrylate d'un alcool polyvalent.

4. Composition durcissable selon l'une quelconque des revendications 1 à 3, dans laquelle le composé (C) est un copolymère comportant les motifs (c1) suivants et les motifs (c2) suivants :
motif (c1) : un motif comportant un groupe alkyle en C₆ à C₂₄ pouvant porter un atome d'oxygène d'éther entre des atomes de carbone et ne comportant ni atome de fluor ni groupe fonctionnel réticulable,
motif (c2) : un motif comportant un groupe fonctionnel réticulable et ne comportant pas d'atome de fluor.

5. Composition durcissable selon la revendication 4, dans laquelle les motifs (c1) sont des motifs formés par polymérisation d'un monomère représenté par la formule (c1m-1) suivante :
CH₂=CX-COO-Rn (c1m-1)
dans laquelle X est un atome d'hydrogène ou un groupe méthyle, et Rn est un groupe alkyle en C₆ à C₂₄ pouvant porter un atome d'oxygène d'éther entre des atomes de carbone.

6. Composition durcissable selon l'une quelconque des revendications 1 à 5, dans laquelle chacun des groupes fonctionnels réticulables dans le prépolymère (A), le composé (B) et le composé (C), qui sont indépendants les uns des autres, est un groupe fonctionnel réticulable choisi dans l'ensemble constitué par un groupe vinyl(oxy), un groupe allyl(oxy), un groupe éthynyle et un groupe (méth)acryloyl(oxy).

7. Composition durcissable selon l'une quelconque des revendications 1 à 6, dans laquelle le composé (B) est contenu en une quantité de 10 à 80 % en masse par rapport à la quantité totale (100 % en masse) du prépolymère (A) et du composé (B).

8. Composition durcissable selon l'une quelconque des revendications 1 à 7, dans laquelle l'amorceur de polymérisation radicalaire (D) est un amorceur de polymérisation thermique (D1) ou un amorceur de photopolymérisation (D2).

9. Composition durcissable selon l'une quelconque des revendications 1 à 8, dans laquelle le composé (C) est contenu en une quantité de 0,1 à 20 parties en masse par rapport à la quantité totale (100 % en masse) du prépolymère (A) et du composé (B).

10. Composition de revêtement comprenant la composition durcissable telle que définie dans l'une quelconque des revendications 1 à 9 et un solvant.

11. Procédé pour produire un film durci, qui comprend la formation d'un film de la composition de revêtement telle que définie dans la revendication 10 sur un substrat, et le durcissement à la chaleur ou le photodurcissement de la composition durcissable par une étape comprenant au moins une étape de chauffage pour produire un film durci, dans lequel la température de chauffage dans chaque étape de chauffage est d'au plus 250°C.

12. Substrat comportant un film durci de la composition durcissable telle que définie dans l'une quelconque des revendications 1 à 9 formé sur celui-ci.

13. Dispositif semi-conducteur comportant un film durci de la composition durcissable telle que définie dans l'une quelconque des revendications 1 à 9.

14. Dispositif semi-conducteur tel que défini dans la revendication 13, qui est un transistor à film mince organique comportant le film durci en tant que film fonctionnel.

15. Dispositif semi-conducteur tel que défini dans la revendication 14, dans lequel le film fonctionnel est un film d'isolation de grille.
